# EUROPEAN PATENT APPLICATION

(11) **EP 4 451 814 A1**
(43) Date of publication of application: **23.10.2024**
(21) Application number: 23753035.7
(22) Date of filing: 26.01.2023
(51) Int. Cl.: H05K 3/46, H05K 1/11, H05K 1/02, H04M 1/02, H05K 1/14

(54) **PRINTED CIRCUIT BOARD ASSEMBLY COMPRISING SPACER HAVING SELF-ALIGNMENT FUNCTION, AND ELECTRONIC DEVICE COMPRISING SAME**

(30) Priority: 09.02.2022 KR 20220016637; 16.03.2022 KR 20220032624
(71) Applicant: Samsung Electronics Co., Ltd, Suwon-si, Gyeonggi-do 16677 (KR)
(72) Inventor: YE, Jaeheung, Suwon-si Gyeonggi-do 16677 (KR); JUNG, Kwangho, Suwon-si Gyeonggi-do 16677 (KR); CHUNG, Yeonkyung, Suwon-si Gyeonggi-do 16677 (KR)
(74) Representative: Walaski, Jan Filip
(86) International application number: PCT/KR2023/001196
(87) International publication number: WO 2023/153684

(57) **Abstract**

A printed circuit board assembly, according to one embodiment, comprises: a first printed circuit board including a first pad having a first recessed groove having a side surface that is recessed obliquely; a second printed circuit board including a second pad that is stacked on the first printed circuit board so as to face the first pad; a spacer positioned between the first pad and the second pad; and a solder applied on the first pad or the second pad so as to electrically connect the first pad and the second pad to each other, wherein the spacer may include a main body and a first protruding body that has a side surface obliquely protruding from one surface of the main body and is inserted into the first recessed groove. Various other embodiments are possible.

## Description

### TECHNICAL FIELD

Various embodiments of the present disclosure relate to a printed circuit board assembly including a spacer with a self-alignment function and an electronic device including the same.

### BACKGROUND ART

An electronic device may include at least one printed circuit board arranged in an inner space. The plurality of printed circuit boards arranged in the inner space of the electronic device may be arranged in a stacked manner to secure an efficient arrangement space.

### DISCLOSURE OF THE INVENTION

### TECHNICAL SOLUTIONS

A printed circuit board assembly may be formed by stacking a plurality of printed circuit boards. In general, the plurality of printed circuit boards may be electrically connected to each other by solders applied to pads formed on the printed circuit boards. Meanwhile, a thermal interface material (TIM) for heat dissipation may be applied inside the printed circuit board assembly. Since the TIM has its volume, a small gap may be generated between two stacked printed circuit boards. To prevent defective bonding between the pads and solders of the printed circuit boards from occurring due to this gap, the process of pressing the stacked printed circuit boards may be applied. However, in the process of pressing the stacked printed circuit boards, the two printed circuit boards may be misaligned. The misalignment between the two printed circuit boards may cause a bridge connecting solders applied to adjacent pads.

According to various embodiments, it is possible to provide a printed circuit board assembly capable of maintaining a predetermined height between two stacked printed circuit boards and an electronic device including the same.

According to various embodiments, it is possible to provide a printed circuit board assembly capable of aligning two stacked printed circuit boards relatively in the process of pressing the two printed circuit boards and an electronic device including the same.

In an embodiment, a printed circuit board assembly 300 may include a first printed circuit board 310 including a first pad 311 having a first recessed groove 312 that is recessed with a side surface 3121 inclined, a second printed circuit board 320 including a second pad 321, the second printed circuit board stacked on the first printed circuit board 310 so that the second pad 321 faces the first pad 311, a spacer 330 positioned between the first pad 311 and the second pad 321, and a solder 340 applied on the first pad 311 or the second pad 321 so that the first pad 311 and the second pad 321 are electrically connected to each other, wherein the spacer 330 may include a main body 331, and a first protruding body 332 that protrudes from one surface of the main body 331 with a side surface 3321 inclined and is inserted into the first recessed groove 312.

In an embodiment, a printed circuit board assembly 300 may include a first printed circuit board 310 including a first pad 311 having a first recessed groove 312 that is recessed with a side surface 3121 inclined, a second printed circuit board 320 including a second pad 321 having a second recessed groove 322 that is recessed with a side surface 3221 inclined, the second printed circuit board stacked on the first printed circuit board 310 so that the second pad 321 faces the first pad 311, a spacer 330 positioned between the first pad 311 and the second pad 321, and a solder 340 applied on the first pad 311 or the second pad 321 so that the first pad 311 and the second pad 321 are electrically connected to each other, wherein the spacer 330 may include a main body 331, a first protruding body 332 that protrudes from one surface of the main body 331 in a shape corresponding to that of the first recessed groove 312 and is inserted into the first recessed groove 312, and a second protruding body 333 that protrudes from the other surface of the main body 331 in a shape corresponding to that of the second recessed groove 322 and is inserted into the second recessed groove 322.

In an embodiment, an electronic device 101 may include at least one printed circuit board assembly 300 arranged inside the electronic device 101, and the printed circuit board assembly 300 may include a first printed circuit board 310 including a first pad 311 having a first recessed groove 312 that is recessed with a side surface 3121 inclined, a second printed circuit board 320 including a second pad 321, the second printed circuit board stacked on the first printed circuit board 310 so that the second pad 321 faces the first pad 311, a spacer 330 positioned between the first pad 311 and the second pad 321, and a solder 340 applied on the first pad 311 or the second pad 321 so that the first pad 311 and the second pad 321 are electrically connected to each other, wherein the spacer 330 may include a main body 331, and a first protruding body 332 that protrudes from one surface of the main body 331 with a side surface 3321 inclined and is inserted into the first recessed groove 312.

### EFFECTS OF THE INVENTION

According to various embodiments, it is possible to maintain a predetermined height between two stacked printed circuit boards by arranging a spacer between the two printed circuit boards.

According to various embodiments, it is possible to align two stacked printed circuit boards relatively in the process of pressing the two printed circuit boards by forming a spacer and a pad to have inclined surfaces that engage with each other.

According to various embodiments, it is possible to enhance the bonding stiffness of solders on a pad where a spacer is positioned.

### BRIEF DESCRIPTION OF DRAWINGS

FIG. 1 is a block diagram illustrating an electronic device 101 in a network environment 100 according to various embodiments.
FIG. 2A is a schematic cross-sectional view of a printed circuit board assembly according to a comparative example.
FIG. 2B is a schematic cross-sectional view illustrating a state in which a bridge is generated in a printed circuit board assembly according to a comparative example.
FIG. 3A is a schematic cross-sectional view of a printed circuit board assembly according to an embodiment.
FIG. 3B is a perspective view of a spacer according to an embodiment.
FIG. 3C is a schematic cross-sectional view illustrating a misaligned state of a printed circuit board assembly according to an embodiment.
FIG. 3D is a schematic cross-sectional view illustrating a self-aligned state of a printed circuit board assembly according to an embodiment.
FIG. 3E is a schematic cross-sectional view of a first printed circuit board and a second printed circuit board according to an embodiment.

### BEST MODE FOR CARRYING OUT THE INVENTION

Hereinafter, embodiments will be described in detail with reference to the accompanying drawings. When describing the embodiments with reference to the accompanying drawings, like reference numerals refer to like components, and any repeated description related thereto will be omitted.

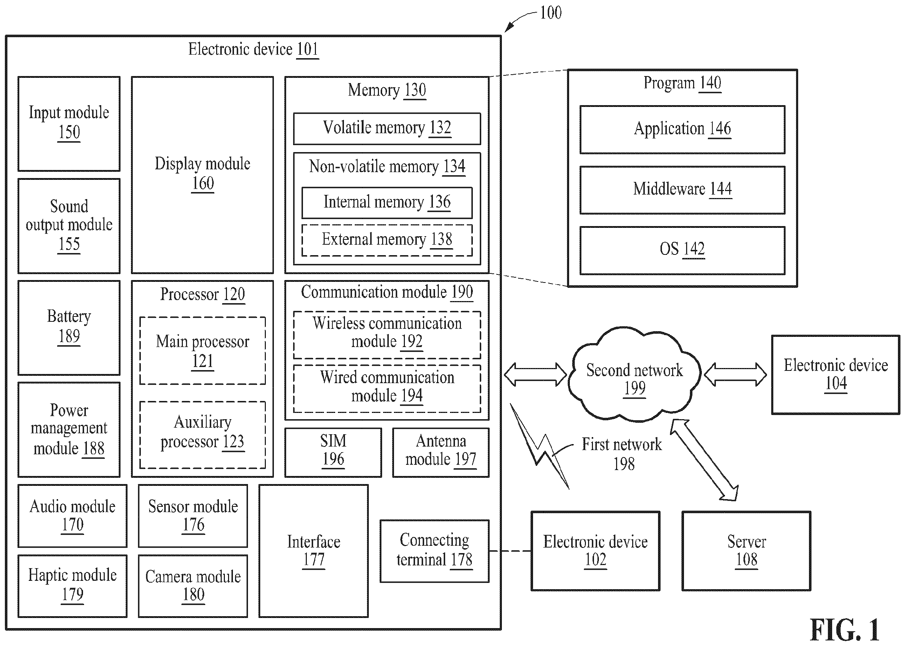

FIG. 1 is a block diagram illustrating an electronic device 101 in a network environment 100 according to various embodiments. Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state, or together with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An artificial intelligence model may be generated by machine learning. Such learning may be performed, e.g., by the electronic device 101 where the artificial intelligence is performed, or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network, or a combination of two or more thereof, but is not limited thereto. The artificial intelligence model may, additionally or alternatively, include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing a record. The receiver may be used for receiving incoming calls. According to an embodiment, the receiver may be implemented separately from the speaker or as a portion of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to sense a touch, or a pressure sensor adapted to measure an intensity of a force incurred by the touch.

The audio module 170 may convert a sound into an electrical signal and vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a portion of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor) and support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth-generation (5G) network, a next-generation communication network, the Internet, or a computer network (e.g., LAN or wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and a next-generation communication technology, e.g., a new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), an array antenna, analog beamforming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a portion of the antenna module 197.

According to various embodiments, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of a same type as, or a different type from, the electronic device 101. According to an embodiment, all or some of operations to be executed by the electronic device 101 may be executed at one or more of external electronic devices (e.g., the external electronic devices 102 and 104, or the server 108). For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms such as "1^{st}," and "2^{nd}," or "first" and "second" may be used to simply distinguish a corresponding component from another, and do not limit the components in other aspect (e.g., importance or order). It is to be understood that if a component (e.g., a first component) is referred to, with or without the term "operatively" or "communicatively," as "coupled with," "coupled to," "connected with," or "connected to" another component (e.g., a second component), the component may be coupled with the other component directly (e.g., wiredly), wirelessly, or via a third component.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least portion of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

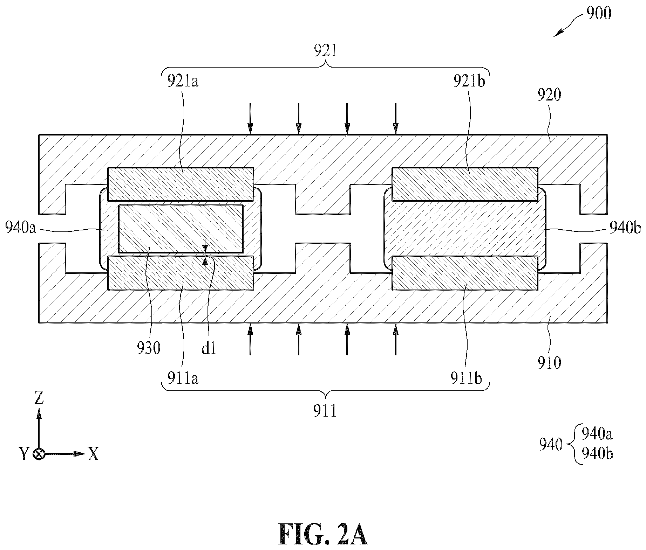

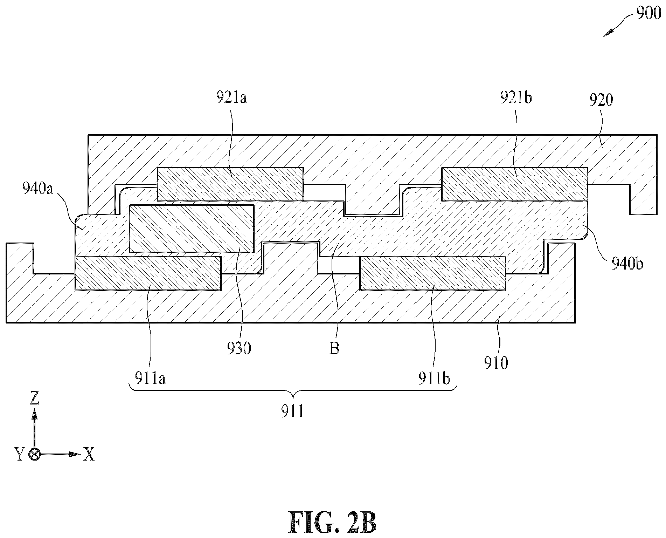

FIG. 2A is a schematic cross-sectional view of a printed circuit board assembly according to a comparative example. FIG. 2B is a schematic cross-sectional view illustrating a state in which a bridge is generated in the printed circuit board assembly according to a comparative example.

Referring to FIGS. 2A and 2B, a printed circuit board assembly 900 according to a comparative example may include a first printed circuit board 910, a second printed circuit board 920, a spacer 930, and a solder 940.

In the comparative example, the first printed circuit board 910 and the second printed circuit board 920 may be stacked together. A first pad 911 formed on the first printed circuit board 910 and a second pad 921 formed on the second printed circuit board 920 may be electrically connected by being bonded to each other using the solder 940. A plurality of first pads 911 and a plurality of second pads 921 may each be formed, and the spacer 930 may be positioned between one first pad 911a and one second pad 921 facing each other. The spacer 930 may be a component to maintain the height between the first printed circuit board 910 and the second printed circuit board 920. The spacer 930 may be formed in a substantially flat cylindrical shape. For example, as shown in FIG. 2A, one first pad 911a and one second pad 921a may be electrically connected by a solder 940a, and another first pad 911b and another second pad 921b positioned adjacent to each other may be electrically connected by a solder 940a.

In the comparative example, to prevent the first pad 911 and the second pad 921 from not contacting the solder 940 due to the gap between the first printed circuit board 910 and the second printed circuit board 920, a process of pressing the first printed circuit board 910 and the second printed circuit board 920 in a stacking direction (e.g., the +z/-z direction) may be applied, as shown in FIG. 2A. However, during this process, a situation in which the first printed circuit board 910 and the second printed circuit board 920 are misaligned may occur, as shown in FIG. 2B. When the first printed circuit board 910 and the second printed circuit board 920 are misaligned, a bridge B connecting the solders 940a and 940b between pads 911a and 911b positioned adjacent to each other may be formed. This bridge B causes a short circuit between the pads 911a and 911b positioned adjacent to each other and thus, may affect the normal operation of the printed circuit board assembly 900.

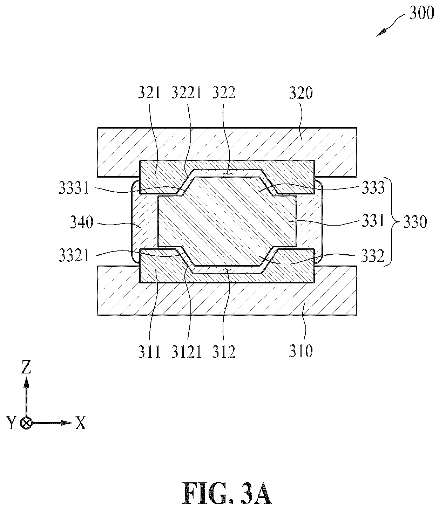

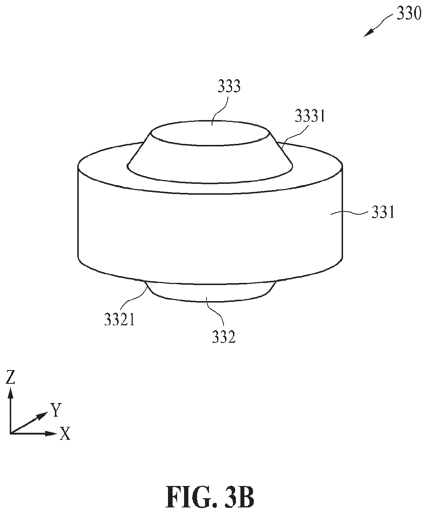

FIG. 3A is a schematic cross-sectional view of a printed circuit board assembly according to an embodiment. FIG. 3B is a perspective view of a spacer according to an embodiment.

Referring to FIGS. 3A and 3B, in an embodiment, a printed circuit board assembly 300 may be applied to various electronic devices (e.g., the electronic device 101 of FIG. 1). At least one printed circuit board assembly 300 may be arranged inside the electronic device 101 to implement various functions of the electronic device 101. For example, the printed circuit board assembly 300 may be applied to a smart phone, a tablet, a laptop computer, a digital broadcasting terminal, a personal digital assistant (PDA), a portable multimedia player (PMP), or a navigation system. However, these are examples, and the electronic device 101 to which the printed circuit board assembly 300 is applicable is not limited thereto.

In an embodiment, the printed circuit board assembly 300 may include a first printed circuit board 310, a second printed circuit board 320, a spacer 330, and a solder 340.

In an embodiment, the first printed circuit board 310 and the second printed circuit board 320 may be boards on which various electronic components (not shown) are arranged. Electric circuits (not shown) electrically connecting various electronic components may be formed on the first printed circuit board 310 and the second printed circuit board 320. The first printed circuit board 310 and the second printed circuit board 320 may be formed in various shapes and/or sizes. For example, the first printed circuit board 310 and the second printed circuit board 320 may be formed in a flat shape or formed to be flexible.

In an embodiment, the first printed circuit board 310 and the second printed circuit board 320 may be stacked together. For example, the first printed circuit board 310 may be a main printed circuit board, and the second printed circuit board 320 may be an auxiliary printed circuit board. Alternatively, for example, the first printed circuit board 310 may be a main printed circuit board, and the second printed circuit board 320 may be an interposer. However, these are examples, and the types of the first printed circuit board 310 and the second printed circuit board 320 are not limited thereto.

In an embodiment, the first printed circuit board 310 may include a first pad 311, and the second printed circuit board 320 may include a second pad 321. The first printed circuit board 310 and the second printed circuit board 320 may be electrically connected through the first pad 311, the second pad 321, and the solder 340. The first pad 311 and the second pad 321 may be formed in corresponding numbers and positioned to face each other. Although FIG. 3A illustrates one first pad 311 and one second pad 321, this is for ease of description, and the number of first pads 311 and the number of second pads 321 are not limited thereto. For example, a single or plurality of first pads 311 and second pads 321 may be formed. The first pad 311 and the second pad 321 may each be electrically connected to the electric circuits (not shown) formed on the first printed circuit board 310 and the second printed circuit board 320.

In an embodiment, the first pad 311 may be formed on one surface (e.g., the +z-directional surface) of the first printed circuit board 310. The first pad 311 may be formed of a metal material to have electrical conductivity. A first recessed groove 312 may be formed in the first pad 311. The first recessed groove 312 may be recessed inward (e.g., in the -z direction) from the outer surface (e.g., the +z-directional surface) of the first pad 311. The first recessed groove 312 may be formed with a side surface 3121 inclined. For example, the first recessed groove 312 may be formed so that the recessed space may substantially have a truncated cone shape or a cone shape.

In an embodiment, the second pad 321 may be formed on one surface (e.g., the -z-directional surface) of the second printed circuit board 310. The second pad 321 may be formed at a position facing the corresponding first pad 311. The second pad 321 may be formed of a metal material to have electrical conductivity. A second recessed groove 322 may be formed in the second pad 321. The second recessed groove 322 may be recessed inward (e.g., in the +z direction) from the outer surface (e.g., the -z-directional surface) of the second pad 321. The second recessed groove 322 may be formed with a side surface 3221 inclined. For example, the second recessed groove 322 may be formed so that the recessed space may have substantially a truncated cone shape or a cone shape.

In an embodiment, the spacer 330 may be positioned between the first pad 311 and the second pad 321. The spacer 330 may maintain the height (e.g., the z-directional height) between the first printed circuit board 310 and the second printed circuit board 320 at a designated height.

In an embodiment, the spacer 330 may include a main body 331, a first protruding body 332, and a second protruding body 333.

In an embodiment, the main body 331 may be formed in a substantially flat cylindrical shape. As shown in FIG. 3A, the cross-sectional area of the main body 331 with respect to the x-y plane may be larger than that of the first recessed groove 312 and/or that of the second recessed groove 322 with respect to the x-y plane.

In an embodiment, the first protruding body 332 may be formed to protrude from one surface (e.g., the -z-directional surface) of the main body 331. The first protruding body 332 may be formed with a side surface 3321 inclined. For example, the first protruding body 332 may be formed substantially in a truncated cone shape or a cone shape. The edge of an end portion (e.g., the -z-directional end portion) of the first protruding body 332 may be rounded. However, this is an example, and the shape of the first protruding body 332 is not limited thereto.

In an embodiment, the first protruding body 332 may be inserted into the first recessed groove 312 of the first pad 311. The first protruding body 332 and the first recessed groove 312 may be formed in shapes substantially corresponding to each other. For example, the inclination angle of the side surface 3321 of the first protruding body 332 may substantially correspond to the inclination angle of the side surface 3121 of the first recessed groove 312. However, this is an example, and the inclination angle of the side surface 3321 of the first protruding body 332 may be greater than or less than the inclination angle of the side surface 3121 of the first recessed groove 312.

In an embodiment, the protruding height (e.g., the z-directional height) of the first protruding body 332 from the main body 331 may be substantially equal to or less than the recess depth (e.g., the z-directional depth) of the first recessed groove 312 from the outer surface (e.g., the +z-directional surface) of the first pad 311. According to this structure, a small gap may be formed between the first protruding body 332 and the first recessed groove 312 such that the solder 340 may be positioned therein. However, this is an example, and the protruding height (e.g., the z-directional height) of the first protruding body 332 from the main body 331 may be less than the recess depth (e.g., the z-directional depth) of the first recessed groove 312 from the outer surface (e.g., the +z-directional surface) of the first pad 311.

In an embodiment, the volume of the first protruding body 332 may be substantially equal to or less than the volume of the first recessed groove 312. However, this is an example, and the volume of the first protruding body 332 may be greater than the volume of the first recessed groove 312.

In an embodiment, the second protruding body 333 may be formed to protrude from the other surface (e.g., the +z-directional surface) of the main body 331. The second protruding body 333 may be formed with a side surface 3331 inclined. For example, the second protruding body 333 may be formed substantially in a truncated cone shape or a cone shape. The edge of an end portion (e.g., the +z-directional end portion) of the second protruding body 333 may be rounded. However, this is an example, and the shape of the second protruding body 333 is not limited thereto.

In an embodiment, the second protruding body 333 may be inserted into the second recessed groove 322 of the second pad 321. The second protruding body 333 and the second recessed groove 322 may be formed in shapes substantially corresponding to each other. For example, the inclination angle of the side surface 3331 of the second protruding body 333 may substantially correspond to the inclination angle of the side surface 3221 of the second recessed groove 322. However, this is an example, and the inclination angle of the side surface 3331 of the second protruding body 333 may be greater than or less than the inclination angle of the side surface 3221 of the second recessed groove 322.

In an embodiment, the protruding height (e.g., the z-directional height) of the second protruding body 333 from the main body 331 may be substantially equal to or less than the recess depth (e.g., the z-directional depth) of the second recessed groove 322 from the outer surface (e.g., the -z-directional surface) of the second pad 321. According to this structure, a small gap may be formed between the second protruding body 333 and the second recessed groove 322 such that the solder 340 may be positioned therein. However, this is an example, and the protruding height (e.g., the z-directional height) of the second protruding body 333 from the main body 331 may be less than the recess depth (e.g., the z-directional depth) of the second recessed groove 322 from the outer surface (e.g., the -z-directional surface) of the second pad 321.

In an embodiment, the volume of the second protruding body 333 may be substantially equal to or less than the volume of the second recessed groove 322. However, this is an example, and the volume of the second protruding body 333 may be greater than the volume of the second recessed groove 322.

In an embodiment, the first protruding body 332 and the second protruding body 333 may be formed to be substantially symmetrical to each other based on the main body 331. However, this is an example, and the first protruding body 332 and the second protruding body 333 may be formed to be asymmetrical to each other based on the main body 331.

In an embodiment, the solder 340 may electrically connect the first pad 311 and the second pad 321. The solder 340 may be applied to the first pad 311 and/or the second pad 321. For example, the solder 340 may be a tin-silver-copper (Sn-Ag-Cu (SAC))-based solder or a bismuth (Bi)-based solder. However, this is an example, and the type of the solder 340 is not limited thereto.

Meanwhile, in an embodiment, the printed circuit board assembly 300 may further include a thermal interface material (TIM) (not shown). The TIM may form a heat conduction path for dissipating the heat inside the printed circuit board assembly 300 to the outside. For example, the TIM may be arranged between the first printed circuit board 310 and the second printed circuit board 320. However, this is an example, and the position of the TIM is not limited thereto.

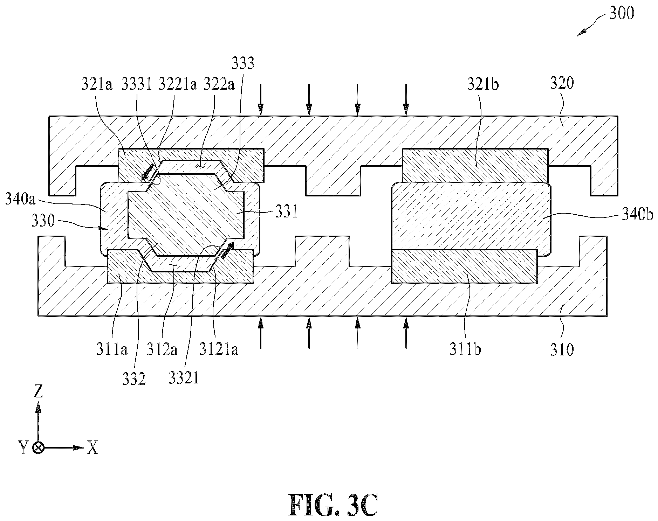

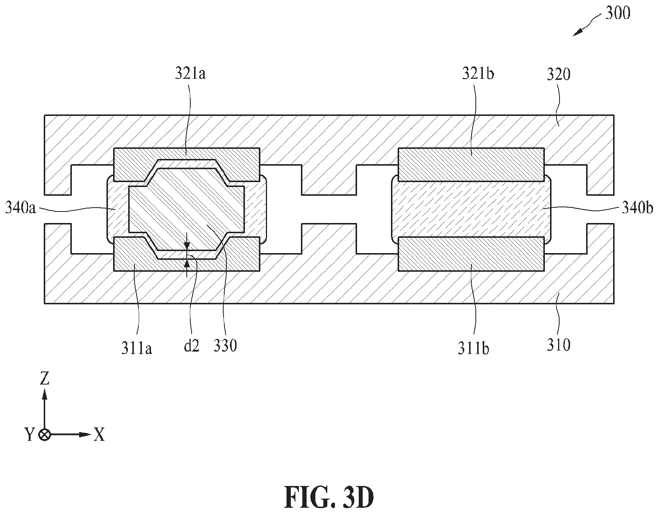

FIG. 3C is a schematic cross-sectional view illustrating a misaligned state of a printed circuit board assembly according to an embodiment. FIG. 3D is a schematic cross-sectional view illustrating a self-aligned state of the printed circuit board assembly according to an embodiment.

Referring to FIGS. 3C and 3D, in an embodiment, the first printed circuit board 310 and the second printed circuit board 320 may include a plurality of first pads 311a and 311b and a plurality of second pads 321a and 321b, respectively. The spacer 330 may be arranged between at least some pairs of first pads 311a and second pads 321a among multiple pairs of first pads 311a and 311b and second pads 321a and 321b. For example, the spacer 330 may be arranged between a first pad 311a and a second pad 321a formed in a portion vulnerable to bending when the first printed circuit board 310 and the second printed circuit board 320 are stacked together. For example, the spacer 330 may be arranged between a first pad 311a and a second pad 321a formed near the edges and/or corners of the first printed circuit board 310 and the second printed circuit board 320. However, this is an example, and the position of the spacer 330 is not limited thereto. Meanwhile, recessed grooves may not be formed in a first pad 311b and a second pad 321b where the spacer 330 is not arranged.

In an embodiment, solders 340a and 340b may be applied to the first pads 311a and 311b of the first printed circuit board 310, respectively. The spacer 330 may be arranged on at least some first pads 311a. The second printed circuit board 320 may be stacked on the first printed circuit board 310 so that the second pads 321a and 321b of the second printed circuit board 320 may be positioned to face the first pads 311a and 311b of the first printed circuit board 310, respectively. However, this is an example, and the order in which the printed circuit board assembly 300 is manufactured is not limited thereto.

In an embodiment, to prevent defective bonding between the solders 340a and 340b and corresponding first pads 311a and 311b and/or second pads 321a and 321b, caused by a gap between the first printed circuit board 310 and the second printed circuit board 320 (e.g., a gap generated by the volume of the TIM (not shown)), the first printed circuit board 310 and the second printed circuit board 320 may be pressed in a stacking direction (e.g., the z direction). In the process of pressing the first printed circuit board 310 and the second printed circuit board 320, the shape in which the spacer 330 and the pads 311a and 321a obliquely engage with each other may enable self-alignment between the first printed circuit board 310 and the second printed circuit board 320. For example, by a force pressing the first printed circuit board 310 and the second printed circuit board 320 in the vertical direction (e.g., the +z/-z direction), the inclined side surfaces 3321 and 3331 of the protruding bodies 332 and 333 and the inclined side surfaces 3121a and 3221a of the recessed grooves 312a and 322a may slide with respect to each other in the directions of thick arrows shown in FIG. 3C. Such sliding may cause the first printed circuit board 310, the spacer 330, and the second printed circuit board 320 to be relatively aligned at the right positions, as shown in FIG. 3D. Therefore, the printed circuit board assembly 300 according to an embodiment may prevent misalignment between the first printed circuit board 310 and the second printed circuit board 320 and further prevent a bridge connecting the solders 340a and 340b applied to the adjacent first pads 311a and 311b, respectively, from being generated.

Referring to FIGS. 2A and 3D, the printed circuit board assembly 300 according to an embodiment may improve the bonding stiffness of the solder 340a compared to the printed circuit board assembly 900 according to the comparative example. For example, as shown in FIG. 2A, the printed circuit board assembly 900 according to the comparative example has a small distance d1 between the first pad 911a and the spacer 930 and thus, may have a small amount of solder 940a positioned between the first pad 911a and the spacer 930. Meanwhile, as shown in FIG. 3D, the printed circuit board assembly 300 according to an embodiment has a relatively great distance d2 between the first pad 311a and the spacer 330 and thus, may have an increasing amount of solder 340a positioned between the first pad 311a and the spacer 330. Therefore, compared to the printed circuit board assembly 900 according to the comparative example, the printed circuit board assembly 300 according to an embodiment may improve the bonding stiffness of the solder 340a as the amount of solder 340a positioned between the first pad 311a and the spacer 330 increases. Meanwhile, although the improvement of the bonding stiffness of the solder 340a has been described based on the first pad 311a and the spacer 330, the description is for ease of description, and the above description may identically apply to the solder 340a positioned between the second pad 321a and the spacer 330.

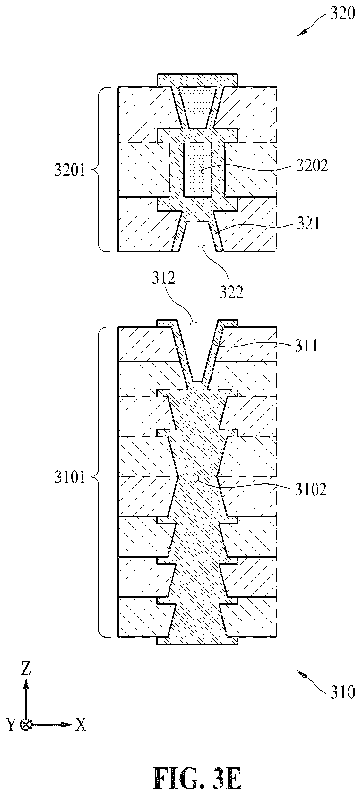

FIG. 3E is a schematic cross-sectional view of a first printed circuit board and a second printed circuit board according to an embodiment.

Referring to FIG. 3E, in an embodiment, the first printed circuit board 310 may include a plurality of first layers 3101 and a first via hole 3102. The plurality of first layers 3101 may be stacked together. Although FIG. 3E illustrates eight first layers 3101, this is an example, and the number of first layers 3101 is not limited thereto. The first via hole 3102 may be formed to penetrate at least a portion of the plurality of first layers 3101. The first via hole 3102 may be filled or plated with a conductive material through via filling. Meanwhile, the first recessed groove 312 may be formed by not performing via filling on at least a portion of the first via hole 3102. For example, as shown in FIG. 3E, the first recessed groove 312 may be formed by not performing via filling on two first layers 3101. In this case, the plated portion on the surface of the first via hole 3102 may function as the first pad 311. However, this is an example, and the first recessed groove 312 may be formed by performing via filling on all or part of the first via hole 3102 and then removing a portion of the filled via.

In an embodiment, the second printed circuit board 320 may include a plurality of second layers 3201 and a second via hole 3202. The plurality of second layers 3201 may be stacked together. Although FIG. 3E illustrates three second layers 3201, this is an example, and the number of second layers 3201 is not limited thereto. The second via hole 3202 may be formed to penetrate at least a portion of the plurality of second layers 3201. The second via hole 3202 may be filled or plated with a conductive material through via filling. Meanwhile, the second recessed groove 322 may be formed by not performing via filling on at least a portion of the second via hole 3202. For example, as shown in FIG. 3E, the second recessed groove 322 may be formed by not performing via filling on one second layer 3201. In this case, the plated portion on the surface of the second via hole 3202 may function as the second pad 321. However, this is an example, and the second recessed groove 322 may be formed by performing via filling on all or part of the second via hole 3202 and then removing a portion of the via fill.

In an embodiment, a printed circuit board assembly 300 may include a first printed circuit board 310 including a first pad 311 having a first recessed groove 312 that is recessed with a side surface 3121 inclined, a second printed circuit board 320 including a second pad 321, the second printed circuit board stacked on the first printed circuit board 310 so that the second pad 321 faces the first pad 311, a spacer 330 positioned between the first pad 311 and the second pad 321, and a solder 340 applied on the first pad 311 or the second pad 321 so that the first pad 311 and the second pad 321 are electrically connected to each other, wherein the spacer 330 may include a main body 331, and a first protruding body 332 that protrudes from one surface of the main body 331 with a side surface 3321 inclined and is inserted into the first recessed groove 312.

In an embodiment, the printed circuit board assembly 300, wherein the first recessed groove 312 and the first protruding body 332 are formed in shapes corresponding to each other.

In an embodiment, the printed circuit board assembly 300, wherein an inclination angle of the side surface 3121 of the first recessed groove 312 and an inclination angle of the side surface 3321 of the first protruding body 332 correspond to each other.

In an embodiment, the printed circuit board assembly 300, wherein a protruding height of the first protruding body 332 is equal to or smaller than a recess depth of the first recessed groove 312.

In an embodiment, the printed circuit board assembly 300, wherein the first printed circuit board 310 and the second printed circuit board 320 are pressed in a stacking direction.

In an embodiment, the printed circuit board assembly 300, wherein the first printed circuit board 310 and the second printed circuit board 320 are relatively aligned in response to sliding between the inclined side surface 3321 of the first protruding body 332 and the inclined side surface 3121 of the first recessed groove 312, in a process of pressing the first printed circuit board 310 and the second printed circuit board 320 in the stacking direction.

In an embodiment, the printed circuit board assembly 300, wherein the second pad 321 has a second recessed groove 322 that is recessed with a side surface 3221 inclined, and the spacer 330 further includes a second protruding body 333 that protrudes from the other surface of the main body 331 with a side surface 3331 inclined and is inserted into the second recessed groove 322.

In an embodiment, the printed circuit board assembly 300, wherein the second recessed groove 322 and the second protruding body 333 are formed in shapes corresponding to each other.

In an embodiment, the printed circuit board assembly 300, wherein an inclination angle of the side surface 3221 of the second recessed groove 322 and an inclination angle of the side surface 3331 of the second protruding body 333 correspond to each other.

In an embodiment, the printed circuit board assembly 300, wherein a protruding height of the second protruding body 333 is equal to or smaller than a recess depth of the second recessed groove 322.

In an embodiment, the printed circuit board assembly 300, wherein the first recessed groove 312 is at least a portion of a via hole formed in the first printed circuit board 310.

In an embodiment, the printed circuit board assembly 300, wherein the main body 331 is formed in a cylindrical shape.

In an embodiment, the printed circuit board assembly 300, wherein the first protruding body 332 is formed in a truncated cone shape or a cone shape.

In an embodiment, the printed circuit board assembly 300, wherein an edge of an end portion of the first protruding body 332 is rounded.

In an embodiment, the printed circuit board assembly 300, wherein the first printed circuit board 310 is a main printed circuit board, and the second printed circuit board 320 is an interposer.

In an embodiment, a printed circuit board assembly 300 may include a first printed circuit board 310 including a first pad 311 having a first recessed groove 312 that is recessed with a side surface 3121 inclined, a second printed circuit board 320 including a second pad 321 having a second recessed groove 322 that is recessed with a side surface 3221 inclined, the second printed circuit board stacked on the first printed circuit board 310 so that the second pad 321 faces the first pad 311, a spacer 330 positioned between the first pad 311 and the second pad 321, and a solder 340 applied on the first pad 311 or the second pad 321 so that the first pad 311 and the second pad 321 are electrically connected to each other, wherein the spacer 330 may include a main body 331, a first protruding body 332 that protrudes from one surface of the main body 331 in a shape corresponding to that of the first recessed groove 312 and is inserted into the first recessed groove 312, and a second protruding body 333 that protrudes from the other surface of the main body 331 in a shape corresponding to that of the second recessed groove 322 and is inserted into the second recessed groove 322.

In an embodiment, a side surface 3321 of the first protruding body 332 and the side surface 3121 of the first recessed groove 312 may be formed to be inclined at corresponding angles, and a side surface 3331 of the second protruding body 333 and the side surface 3221 of the second recessed groove 322 may be formed to be inclined at corresponding angles.

In an embodiment, the first printed circuit board 310 and the second printed circuit board 320 are relatively aligned in response to sliding between the inclined side surface 3321 of the first protruding body 332 and the inclined side surface 3121 of the first recessed groove 312 or sliding between the inclined side surface 3331 of the second protruding body 333 and the inclined side surface 3221 of the second recessed groove 322, in a process of pressing the first printed circuit board 310 and the second printed circuit board 320 in the stacking direction.

In an embodiment, the first recessed groove 312 may be at least a portion of a via hole formed in the first printed circuit board 310, and the second recessed groove 322 may be at least a portion of a via hole formed in the second printed circuit board 320.

In an embodiment, an electronic device 101 may include at least one printed circuit board assembly 300 arranged inside the electronic device 101, and the printed circuit board assembly 300 may include a first printed circuit board 310 including a first pad 311 having a first recessed groove 312 that is recessed with a side surface 3121 inclined, a second printed circuit board 320 including a second pad 321, the second printed circuit board stacked on the first printed circuit board 310 so that the second pad 321 faces the first pad 311, a spacer 330 positioned between the first pad 311 and the second pad 321, and a solder 340 applied on the first pad 311 or the second pad 321 so that the first pad 311 and the second pad 321 are electrically connected to each other, wherein the spacer 330 may include a main body 331, and a first protruding body 332 that protrudes from one surface of the main body 331 with a side surface 3321 inclined and is inserted into the first recessed groove 312.

## Claims

1. A printed circuit board assembly comprising:
a first printed circuit board comprising a first pad having a first recessed groove that is recessed with an inclined side surface;
a second printed circuit board comprising a second pad, the second printed circuit board stacked on the first printed circuit board so that the second pad faces the first pad;
a spacer positioned between the first pad and the second pad; and
a solder applied on the first pad or the second pad so that the first pad and the second pad are electrically connected to each other, wherein
the spacer comprises:
a main body; and
a first protruding body that protrudes from one surface of the main body with an inclined side surface and is inserted into the first recessed groove.

2. The printed circuit board assembly of claim 1, wherein
the first recessed groove and the first protruding body are formed in shapes corresponding to each other.

3. The printed circuit board assembly of claim 1, wherein
an inclination angle of the inclined side surface of the first recessed groove and an inclination angle of the inclined side surface of the first protruding body correspond to each other.

4. The printed circuit board assembly of claim 1, wherein
a protruding height of the first protruding body is equal to or less than a recess depth of the first recessed groove.

5. The printed circuit board assembly of claim 1, wherein
the first printed circuit board and the second printed circuit board are pressed in a stacking direction.

6. The printed circuit board assembly of claim 5, wherein
the first printed circuit board and the second printed circuit board are relatively aligned in response to sliding between the inclined side surface of the first protruding body and the inclined side surface of the first recessed groove, in a process of pressing the first printed circuit board and the second printed circuit board in the stacking direction.

7. The printed circuit board assembly of claim 1, wherein
the second pad has a second recessed groove that is recessed with an inclined side surface, and
the spacer further comprises a second protruding body that protrudes from the other surface of the main body with an inclined side surface and is inserted into the second recessed groove.

8. The printed circuit board assembly of claim 7, wherein
the second recessed groove and the second protruding body are formed in shapes corresponding to each other.

9. The printed circuit board assembly of claim 7, wherein
an inclination angle of the inclined side surface of the second recessed groove and an inclination angle of the inclined side surface of the second protruding body correspond to each other.

10. The printed circuit board assembly of claim 7, wherein
a protruding height of the second protruding body is equal to or less than a recess depth of the second recessed groove.

11. The printed circuit board assembly of claim 1, wherein
the first recessed groove is at least a portion of a via hole formed in the first printed circuit board.

12. The printed circuit board assembly of claim 1, wherein
the main body is formed in a cylindrical shape.

13. The printed circuit board assembly of claim 1, wherein
the first protruding body is formed in a truncated cone shape or a cone shape.

14. The printed circuit board assembly of claim 1, wherein
an edge of an end portion of the first protruding body is round.

15. The printed circuit board assembly of claim 1, wherein
the first printed circuit board is a main printed circuit board, and
the second printed circuit board is an interposer.
